(19) Europäisches Patentamt
European Patent Office
Office européen des brevets

(11) **EP 3 443 362 B1**

(12) **FASCICULE DE BREVET EUROPEEN**

(45) Date de publication et mention de la délivrance du brevet:
**06.10.2021  Bulletin 2021/40**

(21) Numéro de dépôt: **17712513.5**

(22) Date de dépôt: **23.03.2017**

(51) Int Cl.:
*G01Q 30/02* (2010.01)    *G01Q 60/60* (2010.01)
*H01L 21/18* (2006.01)    *G02B 1/11* (2015.01)
*G02B 21/34* (2006.01)

(86) Numéro de dépôt international:
**PCT/EP2017/056982**

(87) Numéro de publication internationale:
**WO 2017/178209 (19.10.2017 Gazette 2017/42)**

(54) **PROCEDE ET APPAREIL DE POSITIONNEMENT D'UN MICRO- OU NANO-OBJET SOUS CONTROLE VISUEL**

VERFAHREN UND VORRICHTUNG ZUR POSITIONIERUNG EINES MIKRO- ODER NANO-OBJEKTS UNTER VISUELLER KONTROLLE

METHOD AND DEVICE FOR POSITIONING A MICRO- OR NANO-OBJECT UNDER VISUAL CONTROL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.04.2016  FR 1653247**

(43) Date de publication de la demande:
**20.02.2019  Bulletin 2019/08**

(73) Titulaires:
• **COMMISSARIAT À L'ÉNERGIE ATOMIQUE ET AUX ÉNERGIES ALTERNATIVES**
  **75015 Paris (FR)**
• **CENTRE NATIONAL DE LA RECHERCHE SCIENTIFIQUE**
  **75016 Paris (FR)**
• **Université du Mans**
  **72085 Le Mans Cedex 09 (FR)**

(72) Inventeurs:
• **CAMPIDELLI, Stéphane**
  **78690 SAINT REMY L'HONORE (FR)**
• **CORNUT, Renaud**
  **92320 CHATILLON (FR)**
• **DERYCKE, Vincent**
  **78180 MONTIGNY-LE-BRETONNEUX (FR)**
• **AUSSERRE, Dominique**
  **72370 SOULITRE (FR)**
• **AUSSERRE, Manuel**
  **69009 LYON (FR)**

(74) Mandataire: **Marks & Clerk France**
**Immeuble "Visium"**
**22, avenue Aristide Briand**
**94117 Arcueil Cedex (FR)**

(56) Documents cités:
**WO-A1-2012/098349    WO-A1-2015/121462**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

L'invention porte sur le positionnement d'un micro- ou nano-objet au-dessus d'un support plan, effectué sous contrôle visuel. Elle se rapporte au domaine des nanotechnologies et s'applique, notamment, à la microscopie à sonde locale (et plus particulièrement à la microscopie électrochimique) et à la nano-fabrication.

On entend par « micro-objet » tout objet ayant au moins une dimension inférieure ou égale à 10 $\mu$m. On entend par « nano-objet » tout objet ayant au moins une dimension inférieure ou égale à 1 $\mu$m voire, selon une définition plus restrictive, à 100 nm (auquel cas on parlera d'objet « sub-micrométrique » entre 100 nm et 1 $\mu$m).

D'une manière générale, il est difficile de positionner et d'orienter précisément des micro-objets, et à plus forte raison des nano-objets, car leur observation n'est pas aisée. Cela tient à la fois à leur faible visibilité intrinsèque et à l'encombrement dû au support plan et aux éléments macroscopiques (micromanipulateurs) permettant leur manipulation.

Un exemple de ces difficultés se rencontre dans le domaine de la microscopie par balayage par sonde locale (SPM, de l'anglais « Scanning Probe Microscopy »), qui recouvre différentes techniques telles que la microscopie à effet tunnel (STM, de l'anglais « Scanning Tunneling Microscopy »), la microscopie à force atomique (AFM de l'anglais « Atomic Force Microscopy ») et la microscopie électrochimique (SECM, de l'anglais « Scanning Electro-Chemical Microscopy »).

Un microscope à balayage par sonde locale - ou simplement microscope à sonde locale - explore une surface point par point le long d'une ligne (position de la sonde selon un axe x), puis ligne par ligne (position de la sonde selon un axe y, perpendiculaire à l'axe x), afin de produire une image S(x,y), où S est un signal relatif à une interaction entre la sonde et la surface. La nature de cette interaction conditionne le type de microscopie considéré : en microscopie à force atomique, on observe la surface grâce à la mesure de la force entre la sonde et la surface ; en microscopie à effet tunnel, on l'observe grâce à la mesure du courant tunnel ; et en microscopie électrochimique, la sonde est immergée dans une solution ionique, et c'est le courant issue des processus électrochimiques au niveau de la surface, dans la solution ou au niveau de la sonde, qui permet d'imager l'échantillon.

Quelle que soit la technique utilisée, l'interaction est toujours fortement dépendante de la distance h entre la sonde et la surface explorée. Par ailleurs, à distance h constante, cette interaction dépend d'au moins une propriété locale p de la surface (par exemple la conductivité en STM), si bien que le signal S est une fonction de x,y,h et p. Plusieurs propriétés locales peuvent affecter simultanément le signal S (par exemple la conductivité locale de la surface et l'interaction de Van der Waals entre la pointe du STM et la surface), ce qu'on peut prendre en compte avec une notation vectorielle **p**. De même d'autres facteurs géométriques que h peuvent aussi affecter S, et notamment l'inclinaison de l'axe de la sonde par rapport à la normale à la surface, qui est un élément particulièrement important dans le cas du SECM. Pour en tenir compte, on peut utiliser là aussi une notation vectorielle, **h**. Au total, le signal délivré par la pointe peut être noté S(x,y, **h**, **p**)

De manière générale, un microscope SPM a deux modes principaux de fonctionnement :

- Dans le premier, dit « à distance constante », on corrige la hauteur h pendant le balayage afin de maintenir le signal S constant, et l'information extraite h(x,y) décrit les reliefs de la surface avec une résolution qui dépend de la finesse de la pointe.
- Dans le second, dit « à hauteur constante », on impose à la sonde de se mouvoir dans un plan z(x,y) qu'on s'efforce en général de maintenir aussi parallèle que possible à la surface de l'échantillon de manière à maintenir la hauteur h(x,y) approximativement constante, et on relève les variations du signal S dues aux autres paramètres, ce qui permet de cartographier une ou plusieurs propriétés **p**(x,y) de la surface.

Comme l'interaction entre la pointe et la surface dépend à la fois de **h** et de **p**, la séparation des deux jeux de paramètres est toujours difficile. Une approche pour dépasser cette difficulté est de relever non plus une mais plusieurs mesures de S en chaque point (amplitude et phase en AFM, par exemple). Pour obtenir ces mesures multiples, on doit faire varier en chaque point l'un des paramètres de contrôle, comme par exemple le potentiel de la sonde en microscopie électrochimique. Par exemple, on peut faire varier la distance h entre la pointe et la surface en chaque point x,y ou moduler cette distance à une fréquence beaucoup plus grande que la fréquence du balayage. Cette approche est particulièrement difficile à mettre en œuvre dans le cas de la SECM, car la grandeur mesurée (un courant électrique) est plus sensible aux propriétés de la surface et de l'électrolyte étudiés qu'à la distance h, alors que dans la plupart des autres techniques de SPM la mesure S dépend très fortement de **h** et plus faiblement de **p**.

Il est donc essentiel de pouvoir mesurer de manière très précise la distance pointe - surface, et cela indépendamment du signal généré par la sonde, afin de pouvoir séparer les informations relatives à la position de la sonde de celles relatives à l'interaction locale avec la surface. De préférence, cette mesure doit en outre être rapide, surtout si elle doit permettre un asservissement afin de réaliser un balayage à distance constante.

Comme cela a été évoqué plus haut, il est également nécessaire de déterminer précisément l'orientation relative de l'extrémité de la sonde par rapport à ses directions de déplacement : les défauts géométriques des sondes font qu'il y a toujours une différence d'orientation entre les axes du déplacement et les axes géométriques de la sonde. Dans le cas particulier de la SECM, où la sonde présente habituellement une pointe aplatie, en forme de disque, avec une région conductrice en son centre, l'inclinaison de la sonde détermine la distance minimale pouvant être atteinte entre cette région conductrice et la surface, ce qui à son tour limite la qualité du signal acquis.

Ainsi, une mise en œuvre efficace de différentes techniques de microscopie à balayage par sonde locale nécessite le positionnement précis et rapide d'un nano-objet (la pointe de la sonde) par rapport à une surface plane. Actuellement, cela est obtenu par des méthodes spécifiques à chaque technique. Dans le cas particulier de la SECM, ces techniques sont particulièrement complexes à mettre en œuvre et ne donnent pas pleine satisfaction ; voir à ce propos l'article de M. A. O'Connell et A. J. Wain « Combined electrochemical-topographical imaging : a critical review » Anal. Methods 2015, 7(17), 6983-6999.

Il existe donc un besoin pour une technique de positionnement d'une sonde SPM, et plus particulièrement d'une sonde SECM, qui soit plus simple et efficace que les méthodes de l'art antérieur, notamment en vue d'un asservissement permettant un balayage à hauteur constante.

Des problèmes tout à fait similaires se présentent dans la mise en œuvre d'autres techniques de micro- ou nano-analyse (utilisant, par exemple, des nano-pipettes) et/ou de micro- ou nano-fabrication (utilisant, par exemple, des sondes SECM pour induire des réactions électrochimiques localisées).

Le problème du positionnement précis d'un micro- ou nano-objet se présente également dans le domaine de la fabrication d'hétérostructures verticales de matériaux bidimensionnels (2D), ou « nanostructures de van der Waals », qui sont des nanostructures tridimensionnelles obtenues par empilement de nano-objets bidimensionnels, tels que des feuillets de graphène ou de matériaux similaires, sur une surface solide. Des travaux récents ont montré que de tels empilements peuvent permettre d'obtenir des dispositifs électroniques ou optoélectroniques tels que des diodes à effet tunnel, des transistors verticaux, des émetteurs ou détecteurs de lumière ; voir par exemple l'article de L. Britnell et al. « Strong Light-Matter Interactions in Heterostructures of Atomically Thin Films », Science 2013, 340, 1311 et celui de T. Georgiou et al. « Vertical Field Effect Transistor based on Graphene-WS2 Heterostructures for flexible and transparent electronics », Nature nanotechnology 2013, 8(2), 100-103. L'empilement peut être obtenu par transferts successifs : les feuillets sont d'abord fixés à des tampons macroscopiques qui sont positionnés à l'aide de micro-manipulateurs, puis libérés en modifiant chimiquement ou en dissolvant les tampons. Le positionnement est une opération critique, car les feuillets bidimensionnels sont pratiquement invisibles ce qui rend difficile tout contrôle visuel. Il est donc nécessaire de procéder par essais, ce qui est très inefficace et limite fortement le nombre de feuillets pouvant être superposés. Contrairement au cas des sondes de microscopie à balayage, où le paramètre le plus critiques est la distance sonde - surface, dans le cas de l'assemblage d'hétérostructures verticales de matériaux 2D c'est surtout la position et l'orientation relative (azimut) des nano-objets dans le plan de la surface qui doit être déterminée précisément. Il est également très important d'assurer le parallélisme entre les tampons et la surface de dépôt, car même une petite inclinaison peut empêcher la mise en contact entre les feuillets à assembler.

L'invention vise à remédier à ces inconvénients de l'art antérieur, et plus précisément à permettre le positionnement d'un micro- ou nano-objet au-dessus d'un support plan par déplacement effectué sous contrôle visuel.

Conformément à l'invention, ce but est atteint grâce à l'utilisation d'une technique optique connue sous l'acronyme BALM (acronyme anglais de « Backside Absorbing Layer Microscopy », c'est-à-dire microscopie à couche absorbante face arrière), décrite dans les documents suivants :

- Ausserré, D., Amra, C., Zerrad, M., & Khachfe, R. A. (2014) « Absorbing Backside Anti-reflecting Layers for high contrast imaging in fluid cells » (No. arXiv: 1405.7672);
- WO 2015/055809 ;
- WO 2015/121462.

Cette technique consiste à utiliser une couche mince absorbante (souvent métallique), déposée à la surface d'un substrat transparent, en tant que couche antireflet amplificatrice de contraste. Un échantillon déposé sur la couche antireflet absorbante, même aussi mince qu'une monocouche atomique, apparait avec un contraste élevé lorsqu'il est éclairé et observé à travers le substrat.

L'article de D. Ausserré et al. « Absorbing Backside Anti-reflecting Layers for high contrast imaging in fluid cells », Journal of Nanomedicine and Nanotechnology, Vol. 05, No. 04, 21 juillet 2014 décrit également des couches antireflet absorbantes et leur application à l'amplification de contraste dans des cellules fluidiques.

Les présents inventeurs se sont rendu compte que les phénomènes interférentiels à l'origine du comportement antireflet de la couche absorbante sont également affectés par la présence d'un micro- ou nano-objet situé à proximité immédiate de ladite couche, mais pas nécessairement en contact direct avec elle, ce qui permet un contrôle visuel du positionnement du micro- ou nano-objet au-dessus de la couche. En effet :

- L'effet amplificateur de contraste de la couche antireflet absorbante rend l'objet aisément visible à travers le substrat, sans que l'observation ne soit perturbée par la présence de micromanipulateurs ; cela permet son positionnement précis dans le plan de la couche.

- L'image de l'objet observé à travers le substrat est très sensible à la distance par rapport à la couche antireflet absorbante ; cela permet de mesurer cette distance, et donc de positionner précisément l'objet selon une direction perpendiculaire à la couche.
- Dans le cas d'un micro- ou nano-objet présentant une surface localement plane (nano-disque à l'extrémité d'une sonde SECM, feuillet de matériau bidimensionnel ...), l'image observée à travers le substrat est également très sensible à l'orientation de cette surface par rapport à la couche antireflet absorbante ; cela permet d'assurer le parallélisme (ou d'obtenir une inclinaison voulue) entre l'objet et la couche.

Le document précité WO 2015/121462 divulgue l'utilisation conjointe d'une couche antireflet absorbante, d'un microscope optique éclairant et observant cette couche à travers le substrat transparent et d'un microscope à balayage par sonde locale agencé du côté de la couche opposé au substrat. Dans ce document il s'agit uniquement d'étudier une réaction chimique à la fois par voie optique et par une mesure électrochimique localisée ; il n'est pas question d'utiliser le microscope pour faciliter le positionnement de la sonde locale.

Un objet de l'invention est donc un procédé de positionnement d'un micro- ou nano-objet au-dessus d'un support plan selon la revendication indépendante 1, comprenant le déplacement dudit micro- ou nano-objet effectué au moyen d'un micromanipulateur et sous contrôle visuel, où :

- ledit micro- ou nano-objet est immergé dans un milieu transparent, dit milieu ambiant, présentant un indice de réfraction $n_3$;
- ledit support plan comprend un substrat transparent d'indice de réfraction $n_0 > n_3$ sur lequel est déposée au moins une couche optiquement absorbante, adaptée pour se comporter en tant que revêtement antireflet lorsqu'elle est éclairée en incidence normale à une longueur d'onde d'éclairage $\lambda$ à travers ledit substrat transparent ; et
- le contrôle visuel comprend l'éclairage dudit micro- ou nano-objet au moins à ladite longueur d'onde $\lambda$ en incidence normale à travers ledit substrat transparent et ladite couche optiquement absorbante, et son observation en réflexion spéculaire également à travers ledit substrat transparent et ladite couche optiquement absorbante, caractérisé en ce que ledit contrôle visuel comprend la caractérisation d'un paramètre choisi parmi la distance entre le micro- ou nano-objet et la couche optiquement absorbante et l'inclinaison du micro- ou nano-objet par rapport à la couche optiquement absorbante, par analyse d'un motif d'interférence optique ou d'une intensité lumineuse réfléchie par ladite couche observé à travers ledit substrat.

Un autre objet de l'invention est un procédé de fabrication d'une nanostructure par empilement de nanostructures bidimensionnelles, comportant le positionnement desdites nanostructures bidimensionnelles par un tel procédé.

Selon une variante du procédé de positionnement selon l'invention, ledit micro- ou nano-objet peut comprendre au moins une micro- ou nano-électrode solidaire d'un support permettant sa manipulation. Un autre objet de l'invention est alors un procédé de réalisation d'au moins un micro- ou nano-contact par dépôt d'au moins une micro- ou nano-électrode sur la surface d'un substrat, ledit dépôt étant réalisé par un tel procédé de positionnement.

Encore un autre objet de l'invention est un microscope à sonde locale selon la revendication indépendante 13 comprenant :

- un support plan comprenant un substrat transparent d'indice de réfraction $n_0$ sur lequel est déposée au moins une couche optiquement absorbante, adaptée pour se comporter en tant que revêtement antireflet lorsqu'elle est éclairée en incidence normale à une longueur d'onde d'éclairage $\lambda$ à travers ledit substrat transparent, et lorsqu'elle est en contact, du côté opposé audit substrat, avec un milieu transparent, dit milieu ambiant, présentant un indice de réfraction $n_3 < n_0$ ;
- une sonde locale, agencée à proximité d'une surface dudit support plan ;
- un système d'actionnement configuré pour déplacer ladite sonde locale au-dessus dudit support plan, au moins dans une direction perpendiculaire et dans une direction parallèle audit support ;
- un système optique configuré pour éclairer ladite sonde locale en incidence normale au moins à ladite longueur d'onde $\lambda$ à travers ledit substrat transparent et ladite couche optiquement absorbante, et l'observer par réflexion spéculaire, également à travers ledit substrat transparent et ladite couche optiquement absorbante ; caractèrisé en ce que
- ledit microscope à sonde locale comprend également un système d'asservissement configuré pour caractériser la distance entre la sonde et la couche optiquement absorbante par analyse d'un motif d'interférence optique ou d'une intensité lumineuse réfléchie observé à travers ledit substrat, et piloter ledit système d'actionnement pour maintenir la distance mesurée égale à une consigne.

Encore un autre objet de l'invention est un appareil d'assemblage de nanostructures selon la revendication indépendante 16 comprenant

- un support plan ;
- un système d'actionnement configuré pour déplacer, autant de fois que nécessaire, au-dessus dudit support plan, un support, auquel peut être fixée une nanostructure bidimensionnelle ;
- un substrat transparent d'indice de réfraction $n_0$ sur lequel est déposée au moins une couche optiquement absorbante, adaptée pour se comporter en tant que revêtement antireflet lorsqu'elle est éclairée en incidence normale à une longueur d'onde d'éclairage $\lambda$ à travers ledit substrat transparent, et lorsqu'elle est en contact, du côté opposé audit substrat, avec un milieu transparent, dit milieu ambiant, présentant un indice de réfraction $n_3 < n_0$ ;
- un système optique configuré pour éclairer ledit support en incidence normale au moins à ladite longueur d'onde $\lambda$ à travers ledit substrat transparent, et l'observer par réflexion spéculaire, également à travers ledit substrat transparent et ladite couche optiquement absorbante;
  un système d'asservissement configuré pour caractériser au moins un des paramètres choisis parmi la distance entre le micro- ou nano-objet et la couche optiquement absorbante et l'inclinaison du micro- ou nano-objet par rapport à la couche optiquement absorbante, par analyse d'un motif d'interférence optique ou d'une intensité lumineuse réfléchie par ladite couche observé à travers ledit substrat, et pour asservir ledit système d'actionnement au moyen de cette caractérisation.

Différents modes de réalisation de l'invention font l'objet des revendications dépendantes.
D'autres caractéristiques, détails et avantages de l'invention ressortiront à la lecture de la description faite en référence aux dessins annexés donnés à titre d'exemple, dans lesquels:

- La figure 1 illustre le principe de la technique BALM, à la base de la présente invention ;
- Les figures 2A et 2B illustrent schématiquement l'application d'une méthode selon un mode de réalisation de l'invention au positionnement d'une sonde locale de microscopie à balayage ;
- La figure 3 illustre schématiquement l'application d'une méthode selon un mode de réalisation de l'invention à l'empilement de feuillets de matériaux bidimensionnels pour l'assemblage d'une hétérostructure verticale de tels matériaux ;
- La figure 4 illustre une variante de l'invention ; et
- Les figures 5A à 8E sont des images optiques de micro et nano-objets illustrant les résultats techniques de l'invention.

Les figures ne sont pas à l'échelle. En particulier l'épaisseur de certaines couches (et notamment de la couche antireflet absorbante) est très fortement agrandie dans un souci de clarté.
Dans la suite, un matériau sera considéré absorbant à une longueur d'onde $\lambda$ lorsque la partie imaginaire de son indice de réfraction à cette longueur d'onde est supérieure ou égale à 0,0001, de préférence à 0,001, de manière encore préférée à 0,01. Dans le cas contraire, il sera considéré transparent.

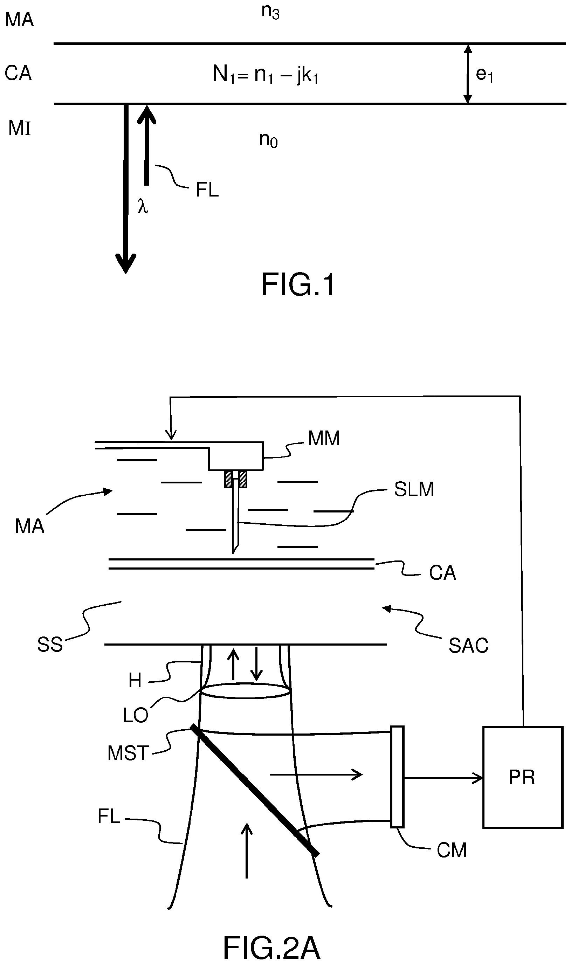

La figure 1 permet de rappeler la théorie des couches antireflet absorbantes, déjà exposée dans la demande internationale précitée WO2015/055809. Elle illustre un faisceau de lumière parallèle FL (pouvant être assimilé localement à une onde plane) et monochromatique à une longueur d'onde (dans le vide) $\lambda$, en incidence normale sur une structure constituée par : un milieu semi-infini dit incident MI, dont provient le faisceau de lumière, transparent et caractérisé par un indice de réfraction réel $n_0$ ; une couche absorbante CA d'épaisseur $e_1$, caractérisée par un indice de réfraction complexe $N_1 = n_1 - jk_1$ (« j » étant l'unité imaginaire) ; et un milieu semi-infini dit émergent, ou milieu ambiant, MA, situé du côté de la couche opposé à celui dont provient la lumière, transparent et caractérisé par un indice de réfraction réel $n_3 < n_0$. Le milieu incident peut notamment être un substrat, par exemple en verre, sur lequel est déposée la couche CA.
La couche CA est dimensionnée de telle sorte que la réflectance de l'ensemble milieu incident MI / couche CA / milieu ambiant MA soit aussi faible que possible, et idéalement nulle. Toute perturbation de la structure (la présence d'un échantillon sur la couche CA dans le cas des applications connues de la technique BALM ; la proximité immédiate d'un micro- ou nano-objet dans le cas de l'invention) provoque une augmentation sensible de l'intensité réfléchie, et est donc détectée aisément.
Le coefficient de réflexion complexe d'une structure du type illustré sur la figure 1 (couche d'épaisseur $e_1$ comprise entre deux milieux semi-infinis) est donné par la formule d'Airy :

$$r_{013} = \frac{r_{01} + r_{13} e^{-2j\beta_1}}{1 + r_{01} r_{13} e^{-2j\beta_1}} \qquad (2)$$

où $r_{ij}$ est le coefficient de Fresnel à l'interface i-j (i,j=0, 1 ou 3, « 0 » correspondant au milieu incident, « 1 » à la couche CA et « 3 » au milieu émergent) et $\beta_1 = 2\pi n_1 e_1 \cos\theta_1/\lambda$ est le facteur de phase associé à ladite couche, $\theta_1$ étant l'angle de réfraction dans la couche. Dans un premier temps, on considère une couche transparente d'indice réel $n_1$, la généralisation au cas d'une couche absorbante sera traitée plus loin. Toujours dans un premier temps, on considère une incidence qui peut ne pas être normale.

Les coefficients de Fresnel pour les polarisations « p » (TM) et « s » (TE) sont :

$$r_{ij}^{(p)} = \frac{\left(n_j \cos\theta_i - n_i \cos\theta_j\right)}{\left(n_j \cos\theta_i + n_i \cos\theta_j\right)}$$

et

$$r_{ij}^{(s)} = \frac{\left(n_i \cos\theta_i - n_j \cos\theta_j\right)}{\left(n_i \cos\theta_i + n_j \cos\theta_j\right)}$$

La condition antireflet correspond à $r_{013}=0$ ce qui, dans le cas de milieux transparents (indices réels) donne deux familles de solutions :

- les couches dites « λ/2 », pour lesquelles $e_1 = \dfrac{m\lambda}{(2n_1 cos\theta_1)}$ où m est un entier, qui existent seulement si $n_0=n_3$ ; et

- les couches dites « λ/4 », pour lesquelles $n_1 e_1 = (2p + 1)\dfrac{\lambda}{4}$ (p entier).

Dans le cas où le milieu 1 (couche CA) est absorbant, son indice de réfraction $N_1=n_1-jk_1$ est complexe ; l'angle de réfraction - que l'on indique alors par $\Theta_1$ - et le coefficient de phase - $B_1$ - sont également complexes. Dans ce cas, $r_{013}=0$ impose : $r_{01,s} \cdot r_{13,p}= r_{01,p} \cdot r_{13,s}$ ; cette égalité ne peut être vraie que si une des trois conditions suivantes : $\Theta_1=0$ (incidence normale), $N_1^2=n_0^2$ (pas de couche) ou $n_0^2=n_3^2$ (milieux incident et émergent identiques) est satisfaite. Par conséquent, dans le cas de milieux extrêmes quelconques, la condition antireflet ne peut être satisfaite qu'en incidence normale. Sachant que $r_{011,p}=-r_{01,s}$ et que $r_{13,p}=-r_{13,s}$, l'équation (2) devient :

$$N_1^2 - j\frac{(n_3-n_0)}{tanB_1}N_1 - n_0 n_3 = 0 \qquad\qquad (3)$$

L'équation (3) est transcendante et n'admet pas de solution analytique. Toutefois, on peut trouver des solutions correspondant aux cas extrêmes : couche réalisée en un matériau fortement absorbant et couche réalisée en un matériau faiblement absorbant. Il convient de noter qu'une couche réalisée en un matériau fortement absorbant mais très mince peut, en fait, absorber moins de lumière qu'une couche réalisée en un matériau faiblement absorbant mais plus épais.

Dans le cas d'un matériau fortement absorbant, on peut supposer que $e_1 \ll \lambda$ car la lumière ne se propagerait pas à travers une couche épaisse d'un tel matériau ; par conséquent, $|B_1|<<1$ et on peut alors écrire, au second ordre en $B_1$ : $tanB_1 \cong B_1 = \sqrt{n_3/n_0}\left(N_1/\sqrt{n_0 n_3}\right)\delta_1$, où $\delta_1 = (2\pi n_0/\lambda)e_1$. Il est utile de séparer les parties réelles et imaginaires de l'équation, et d'utiliser les variables « réduites » $v_1 = n_1/\sqrt{n_0 n_3}$ and $\kappa_1 = k_1/\sqrt{n_0 n_3}$. L'équation (3) peut alors s'écrire sous la forme du système suivant :

$$v_1^2 = 1 + \kappa_1^2 \qquad\qquad (4a)$$

$$\delta_1 = \frac{\left(\frac{n_0}{n_3}-1\right)}{2v_1\kappa_1} \tag{4b}$$

Etant donné que $\delta_1$ doit être réel et positif, on a la condition $n_0 > n_3$ (« géométrie inversée »). En prenant $n_0 = 1,52$ et $n_3 = 1,34$ - ce qui correspond au cas verre/eau couramment utilisé en biophotonique - on trouve une épaisseur $e_1 = (\lambda/2\pi)(n_0 - n_3)/2n_1k_1$ de l'ordre du nanomètre, ce qui confirme l'hypothèse initiale. Il est intéressant - et inattendu - que l'équation (4a) tend à la condition d'indice classique quand $\kappa_1$ - et donc $k_1$ - tend vers zéro. Une comparaison avec des résultats numériques permet de vérifier que l'équation (4a), bien que dérivée dans l'hypothèse d'une couche en matériau fortement absorbant, est approximativement valable pour toute valeur de $k_1$. Par contre, la valeur de $e_1$ obtenue à partir de l'équation (4b) ne tend pas vers $\lambda/4n_1$ ; par conséquent, l'équation (4b) n'a pas une validité générale.

Dans le cas d'un matériau faiblement absorbant on pose $B_1 = \pi/2 - \varepsilon_1$ (où $\varepsilon_1$ est une variable complexe), ce qui implique : $\varepsilon_1 = \pi/2 - \sqrt{\frac{n_3}{n_0}}(v_1 - j\kappa_1)\delta_1$. On peut alors écrire, au second ordre en $\kappa_1$ :

$$v_1{}^2 = 1 + \frac{\pi}{2}\sqrt{\frac{n_3}{n_0}}\left(\frac{n_0}{n_3}-1\right)\kappa_1 - 3\kappa_1{}^2 + o\left(\kappa_1{}^3\right) \tag{5a}$$

$$\delta_1 \simeq \frac{\pi}{2}\sqrt{\frac{n_0}{n_3}}\frac{1}{v_1}\left\{1 - \frac{4}{\pi}\frac{\sqrt{n_0/n_3}}{(n_0/n_3-1)}\kappa_1 + \kappa_1{}^2 + o\left(\kappa_1{}^3\right)\right\} \tag{5b}$$

En pratique, l'équation (5a) - dont le domaine de validité s'avère très réduit - a peu d'intérêt car, comme mentionné plus haut, l'équation (4a) constitue une approximation satisfaisante pour toute valeur de $\kappa_1$. En calculant la solution numérique de l'équation 3 on peut vérifier que la solution obtenue pour $\kappa_1$ élevé ne constitue pas une approximation acceptable pour $\kappa 1$ pour $\kappa_1$ petit. Par contre, il existe une équation semi-empirique qui s'avère satisfaisante dans tous les cas et qui est donnée par l'équation 6b ci-dessous ; l'équation 6a est simplement l'équation 4a qui, comme cela a été montré plus haut, peut être considérée générale et utilisée en remplacement de 5b même pour $\kappa_1$ petit :

$$v_1{}^2 = 1 + \kappa_1{}^2 \tag{6a}$$

$$\delta_1 \cong \frac{(n_0/n_3-1)}{2v_1\kappa_1}\left[1 - e^{-\frac{\kappa_1}{K}}\right] \tag{6b}.$$

où

$$K = \left\{[\pi/(n_0/n_3 - 1)]\sqrt{n_0/n_3}\right\}^{-1}$$

En pratique, bien qu'étant moins contraignante que la condition 1a qui s'applique aux couches antireflet transparentes la condition 6a reste très contraignante. En pratique, on peut souvent se contenter de ne satisfaire que la condition 6b de manière exacte ou approchée, par exemple avec une tolérance sur $e_1$ de l'ordre de $\lambda/200$, voire $\lambda/100$, voire de $\lambda/20$ voire même de $\lambda/10$ ; en termes de $\delta_1$ cela se traduit par une tolérance de l'ordre de 0,005, voire 0,01, voire 0,05 voire même 0,1.

Il est donc particulièrement utile d'introduire une hiérarchie entre les conditions 6a et 6b, qui est justifiée par l'analyse suivante :

L'interférence destructive entre les faisceaux réfléchis par les deux surfaces f' une couche antireflet absorbante résulte de deux contributions :

i) l'amplitude des coefficients de réflexion de ces deux surfaces ;
ii) le déphasage entre les faisceaux réfléchis par ces deux surfaces, auquel contribue la différence de déphasage à la réflexion par chacune des deux surfaces et le trajet optique qui les sépare.

L'équation 6a traduit que l'amplitude des coefficients de réflexion est identique : L'équation 6b traduit que les faisceaux émergents sont en opposition de phase.

Si les deux équations sont simultanément satisfaites, l'extinction est totale.

Si seule l'équation 6a est satisfaite, les fluctuations de l'intensité réfléchie par la couche avec son épaisseur sont maximales, ce qui garantit la possibilité d'une extinction parfaite, mais ne garantit pas l'extinction, pas même une extinction satisfaisante.

Si seule l'équation 6b est satisfaite, l'extinction n'est pas forcément parfaite, parce que les amplitudes réfléchies par les deux surfaces peuvent être différentes, mais l'épaisseur de la couche est telle que l'extinction est satisfaisante parce que le chemin optique est réglé pour que ces deux réflexions soient en opposition de phase ou "presque" en opposition de phase. On pourra parler dans ce cas d'une couche anti-résonante. Le mot "presque" traduit le fait que les écarts à la condition 6a affectent les phases des amplitudes réfléchies par les deux surfaces, et qu'ils les affectent faiblement. C'est pourquoi il est plus important d'approcher la condition 6b que d'approcher la condition 6a. En pratique, l'indice $N_1 = n_1 - jk_1$ varie beaucoup avec la longueur d'onde $\lambda$ et le produit $\nu_1 \kappa_1$ parcourt un intervalle [p1, p2]. Il faut donc choisir pour quelle longueur d'onde cible on optimise l'épaisseur de la couche. Les variations du produit $\nu_1 \kappa_1$ avec la longueur d'onde suffisent à rattraper, par le choix de la longueur d'onde de travail, l'erreur faite sur l'épaisseur en utilisant l'équation 6b avec la longueur d'onde cible quand l'équation 6a n'est pas vérifiée.

Il est donc particulièrement judicieux :

i) de s'approcher de la condition 6a autant que faire se peut (par exemple avec une tolérance inférieure ou égale à 20%, de manière préférée inférieure ou égale 5%, et de manière encore préférée inférieure ou égale à 1%, pour $n_1$ et $k_1$, mais on sera parfois amenés à accepter des tolérances plus élevées) compte tenu des contraintes imposées sur les matériaux;
ii) de choisir une longueur d'onde cible telle que le produit $\nu_1 \kappa_1$ correspondant se situe vers le milieu de l'intervalle [p1, p2];
iii) de déterminer l'épaisseur réduite $\delta_1$ de la couche au moyen de l'équation 6b appliquée avec cette longueur d'onde cible.
iv) de choisir la longueur d'onde de travail qui procure la meilleure extinction.

En outre, les performances d'une couche antireflet absorbante non idéale, c'est-à-dire vérifiant de manière exacte ou approchée la condition 6b (couche « anti-résonante ») mais pas la condition 6a, par exemple en métal, peuvent être améliorées en déposant au-dessus d'elle un petit nombre (entre 1 et 5) de feuillets d'un matériau de type graphène.

Il convient de noter que, bien que qualifiée de « absorbante », la sous-couche de contraste ne doit pas nécessairement être constituée d'un matériau absorbant au sens propre : en variante, il peut s'agir d'une couche constituée d'un matériau diffusant, la diffusion « imitant » l'absorption et pouvant également être modélisée par un indice de réfraction complexe. Ainsi, l'expression « couche optiquement absorbante » désigne de manière générale toute couche réalisée en un matériau, absorbant ou diffusant, pouvant être caractérisé par un indice de réfraction complexe avec une partie imaginaire non négligeable (par exemple supérieure ou égale à 0,0001, de préférence à 0,001, de manière encore préférée à 0,01).

Les couches antireflet absorbantes utilisées dans l'invention présentent typiquement une épaisseur inférieure ou égale à 100 nm, et de préférence à 40 nm.

L'utilisation d'une couche antireflet absorbante pour assister le positionnement d'un micro- ou nano-objet est particulièrement avantageuse, par rapport à l'utilisation d'une couche antireflet diélectrique conventionnelle, pour au moins deux raisons :

- comme cela a été expliqué plus haut, le caractère absorbant de la couche antireflet permet de relâcher les contraintes sur son indice de réfraction ;
- que ce soit pour l'acquisition d'images SPM ou pour l'assemblage de nanostructures, le positionnement de micro- ou nano-objet doit souvent se faire au-dessus de surfaces métalliques, qui sont compatibles avec la technologie BALM mais pas avec d'autres techniques d'observation telles que la visualisation directe par un microscope optique inversé.

La figure 2A représente un microscope à balayage par sonde locale comprenant une sonde SLM pouvant être déplacée selon trois dimensions spatiales par un système d'actionnement, ou micromanipulateur, MM. Il peut par exemple s'agir d'un microscope électrochimique (SECM), auquel cas la sonde SLM peut se présenter, par exemple, sous la forme d'un capillaire en verre entourant une nano-électrode métallique et présentant une surface d'extrémité en forme de disque exposant, en son centre, ladite nano-électrode. La sonde SLM peut également se présenter sous la forme d'un capillaire en verre contenant, à l'intérieur de sa lumière, une solution ionique. Il s'agira alors d'une nanopipette, qui peut servir à délivrer une solution contenant différentes espèces chimiques, ou à détecter un comportement électrochimique local. Lorsque le solvant dans la nanopipette n'est pas miscible au solvant entourant la nanopipette, on parle alors de ITIES, pour « interface between two imiscible electrolyte solutions » (interface entre deux solutions électrolytes immiscibles). Le micromanipulateur MM est configuré pour déplacer la sonde SLM au-dessus de la surface d'un support amplificateur de contraste SAC comprenant un substrat transparent SS, par exemple en verre ou en plastique transparent tel qu'un polycarbonate ou un polystyrène, sur lequel est déposée une couche antireflet absorbante CA. La couche CA est en contact avec un milieu ambiant MA dans lequel est immergée la sonde SLM ; il pourra s'agir par exemple d'une solution électrolytique. L'ensemble substrat SS - couche CA - milieu MA forme un système du type décrit plus haut en référence à la figure 1, le substrat SS jouant le rôle de milieu incident MI.

Le substrat est éclairé en incidence normale (plus précisément, par un cône de lumière autour de la normale) par un faisceau lumineux FL qui est, dans l'exemple considéré ici, un faisceau laser à profil gaussien, focalisé par un objectif à immersion LO au niveau de la couche antireflet (la référence H désigne la goutte d'huile destinée à éviter les réflexions par la face arrière du substrat). On sait en effet que, dans sa région focale (« beam waist »), un faisceau gaussien présente un front de phase plan, et peut donc être assimilé localement à une onde plane (cas considéré dans les développements théoriques qui précèdent). Un miroir semi-transparent MST dévie une portion de la lumière réfléchie par l'ensemble substrat SS / couche absorbante CA / milieu ambiant MA, pour la diriger vers un capteur matriciel CM, relié à un processeur PR assurant un traitement numérique des images acquises par le capteur CM. La nature de ce traitement sera discutée plus loin.

En supposant un dimensionnement idéal de la couche CA pour une longueur d'onde $\lambda$, un éclairage monochromatique à cette longueur d'onde, en l'absence de sonde locale SLM et en supposant que le milieu ambiant MA s'étend sur une épaisseur macroscopique, l'ensemble SS/CA/MA ne devrait pas réfléchir de lumière. La présence de la sonde locale SLM à proximité de la couche CA perturbe cette situation d'extinction de la réflexion. Comme l'extinction est le plus souvent imparfaite, la proximité de la sonde peut y participer ou l'altérer. La sonde est donc observée comme une tache brillante sur fond noir ou comme une tache sombre sur un fond moins sombre. L'intensité et l'étendue de cette tache dépendent de façon monotone de la distance entre pointe et surface. En pratique, on utilisera le plus souvent un éclairage non monochromatique et le dimensionnement de la couche antireflet sera approximatif, mais le résultat restera qualitativement le même.

Dans l'exemple de la figure 2A, l'éclairage est réalisé en lumière cohérente au moyen d'un laser, mais cela n'est ni essentiel, ni nécessairement avantageux. En cas d'éclairage cohérent, l'utilisation d'un disque diffusant tournant sur le faisceau laser incident permet d'éliminer les interférences parasites de type chatoiement (« speckle » en anglais). En variante, il est possible d'utiliser un large faisceau de lumière parallèle, non nécessairement cohérente. L'utilisation d'un éclairage polarisé linéairement n'est pas essentielle, mais peut améliorer la sensibilité à l'inclinaison du nano-objet.

Dans la plupart des cas on utilisera un cône d'éclairage ayant un demi-angle d'ouverture pouvant atteindre 60°, mais souvent de l'ordre de 20° - 30° ou moins, centré autour de la direction d'incidence normale ou, en tout cas, incluant cette direction. L'utilisation d'un objectif à immersion est avantageuse, mais d'autres systèmes optiques d'éclairage et de formation d'images peuvent être utilisés.

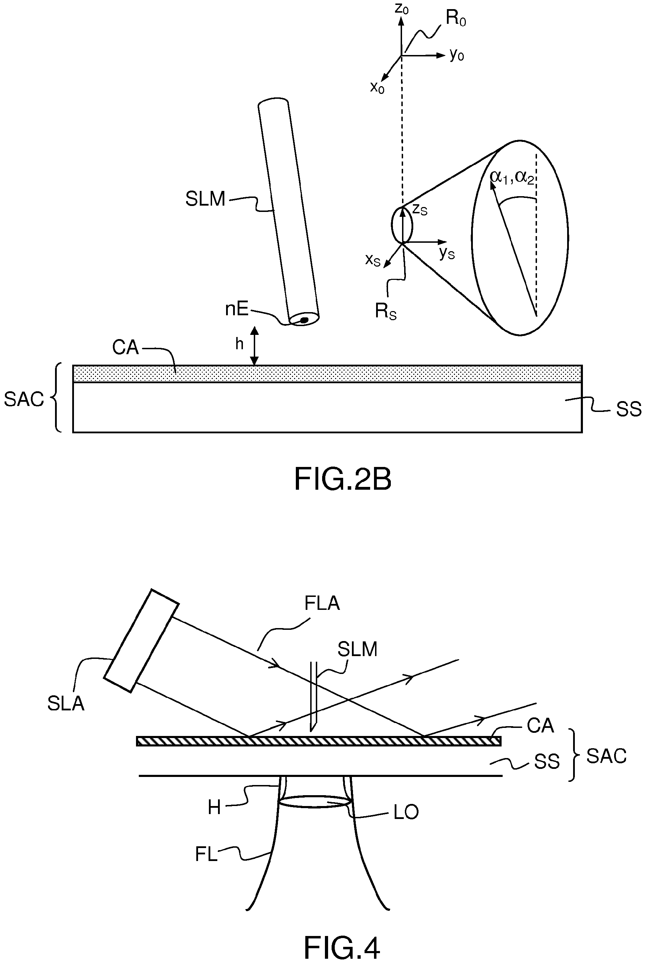

L'observation de la sonde SLM à travers le support amplificateur de contraste SAC permet son positionnement dans le plan x-y parallèle à la couche CA, mais également la mesure (plus généralement, la caractérisation) de sa distance h à ladite couche et de son orientation, et par conséquent le contrôle de ces deux paramètres. La figure 2B montre une vue de détail d'une sonde SLM pour SECM dont l'extrémité se trouve à une distance h de la surface de la couche antireflet absorbante CA. En général, la sonde n'est pas parfaitement perpendiculaire à la surface ; son orientation peut être définie par deux angles $\alpha_1$, $\alpha_2$, exprimant la rotation entre un repère $R_s$ solidaire de la sonde (axes $x_s$, $y_s$, $z_s$) et un repère $R_0$ solidaire de la surface (axes $x_0$ et $y_0$, parallèles à la surface, et axe normal $z_s$). La connaissance de l'inclinaison est importante pour deux raison :

- elle doit être corrigée autant que possible, afin de pouvoir approcher au maximum la nano-électrode nE au centre de la sonde de la surface ;
- si l'inclinaison est due à la mauvaise orientation du micromanipulateur, un déplacement de la sonde dans le plan $x_s - y_s$, nominalement parallèle à la surface mais en réalité incliné, induira en fait une variation de la hauteur h, nécessitant une correction.

L'approche d'une sonde de microscopie à balayage, telle qu'une sonde SECM, de la surface de la couche antireflet absorbante CA comprend une première phase d'approche grossière et une deuxième phase d'approche fine.

Dans l'approche grossière, on n'exploite pas nécessairement la technique BALM. Simplement, la sonde SLM est observée à travers le support SAC, qui est semi-transparent, au moyen de l'objectif LO ; l'amplification de contraste due à la technique BALM est réellement exploitée seulement si la pointe de la sonde est très petite (nanométrique) ou si son indice est très proche de celui du milieu ambiant, par exemple dans le cas ou la sonde est un tampon de PDMS ou une pipette et l'indice du liquide élevé (mais moins que celui du support).

En mettant au point alternativement sur la couche CA et sur la sonde SLM on peut estimer leur distance avec une précision maximale qui est définie par la profondeur de champ de l'objectif - typiquement 500 nm dans le cas d'un microscope à champ large et 100 nm dans le cas d'un microscope confocal.

Une fois que la pointe de la sonde s'est rapprochée de la couche CA à une distance de quelques centaines ou dizaines de nanomètres au plus, les interactions de champ proche entre la pointe et la couche absorbante commencent à affecter le fonctionnement de la technique BALM. Ce qu'on observe via l'objectif LO n'est pas une simple image de la pointe, mais un motif d'interférence dont la forme, l'intensité et, si l'éclairage n'est pas monochromatique, la couleur dépendent très fortement de la distance h. En comparant des images de ce motif, acquises par le capteur matriciel CM, avec des images de référence correspondant à des valeurs connues de h, il est possible de mesurer précisément cette distance. La comparaison peut être effectuée par un opérateur, mais est de préférence effectuée de manière automatique, au moyen d'un algorithme conventionnel de traitement d'images (basé, par exemple, sur des calculs de corrélations croisées) mis en œuvre par le processeur PR recevant en entrée des signaux issus du capteur CM et stockant dans une mémoire les images de référence. Cela présuppose une étape préalable d'étalonnage, qui peut être mise en œuvre de la manière suivante :

- d'abord, on positionne une sonde quelques centaines de nanomètres au-dessus de la couche CA ;
- puis on l'approche pas à pas de la surface de la couche, avec des pas d'amplitude connue, et on acquiert une image du motif d'interférence BALM (image de référence) pour chaque position.

A un moment donné, la sonde touche la surface de la couche; à ce point on sait que h=0. L'amplitude du pas de déplacement étant connue, on est en mesure de déterminer la valeur de h associée à chaque image de référence.

En variante, les images de référence peuvent être obtenues par simulation numérique.

Dans le cas où l'objectif n'est pas de mesurer mais simplement de maintenir la distance h constante, on peut exploiter toute caractéristique monotone de la perturbation locale de l'aspect de la surface apportée par la proximité de la pointe pour y parvenir, telle que la position d'une frange d'interférence, le diamètre d'un anneau d'interférence, une simple variation locale d'intensité ou de couleur à la verticale de la sonde ou le diamètre de la zone perturbée autour de cette verticale.

Par "motif d'interférence", on entend donc toute perturbation de l'aspect de la surface induit par la proximité de la sonde.

Une éventuelle inclinaison de la sonde par rapport à la normale à la couche CA induit un défaut de parallélisme entre son extrémité plane et ladite souche, ce qui à son tour se traduit par une asymétrie du motif d'interférence BALM. Une quantification de cette asymétrie, au moyen de techniques classiques de traitement du signal, permet d'estimer les angles $\alpha_1$, $\alpha_2$ qui définissent l'orientation de la sonde (cf. figure 2B). La mesure des angles $\alpha_1$, $\alpha_2$ peut être rendue plus précise grâce à l'utilisation d'un éclairage polarisé linéairement, et plus particulièrement présentant une polarisation tournante. En revanche, il n'est pas nécessaire d'observer à travers un analyseur de polarisation.

Une source possible d'asymétrie du motif d'interférence BALM peut aussi être les défauts de cylindricité de la sonde. Ainsi, les asymétries du motif d'interférence que l'on n'arrive pas à annuler par le changement des angles $\alpha_1$, $\alpha_2$ vont nous donner des informations sur la géométrie de la sonde elle-même. Dans le cas particulier des microélectrodes, par exemple, il devient ainsi possible de connaitre différents paramètres associés à la géométrie de la sonde telle que la forme de la gaine de verre ou l'excentricité du conducteur par rapport au verre. Il est en effet important de connaitre ces paramètres pour une interprétation quantitative des mesures SECM.

Dans le cas où l'objectif n'est pas de mesurer mais simplement de maintenir l'inclinaison constante, on peut également exploiter toute caractéristique monotone de la perturbation locale de l'aspect de la surface apportée par un défaut de parallélisme pour y parvenir.

Ainsi, dans certain cas, il ne sera pas nécessaire de mesurer, au sens propre, la distance et/ou l'inclinaison de la pointe, et on pourra se satisfaire de les caractériser de manière qualitative.

Les mesures de distance h et d'inclinaison de la sonde, ou plus généralement leurs caractérisations qualitatives - peuvent être utilisées pour mettre en œuvre un asservissement du micromanipulateur MM, par exemple afin de réaliser un balayage de la couche CA à h constant (ou, plus généralement, avec une distance h et/ou une inclinaison de la sonde suivant une consigne). La figure 2A illustre schématiquement une telle boucle d'asservissement.

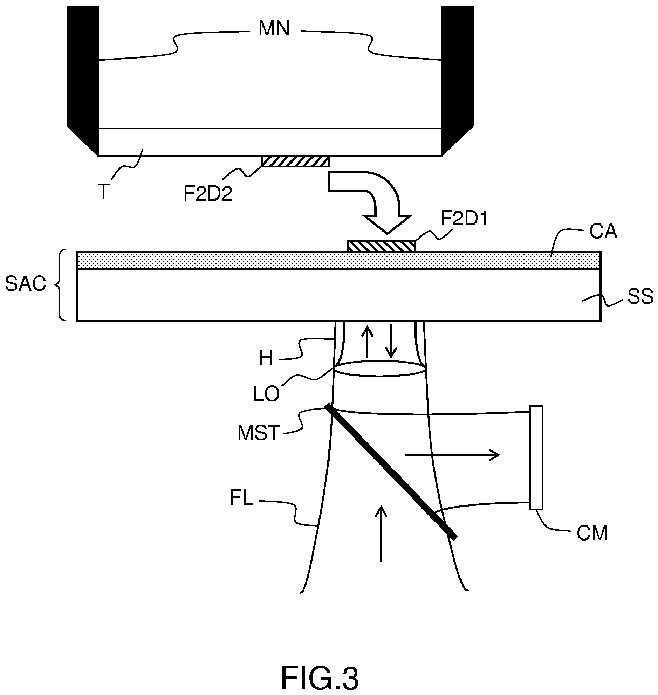

La figure 3 illustre l'application du principe de l'invention à l'assemblage d'hétérostructures verticales par empilement de matériaux bidimensionnels. La figure montre un support amplificateur de contraste SAC, sur la couche antireflet absorbante CA duquel a été déposé un feuillet F2D1 d'un premier matériau bidimensionnel. Un autre feuillet F2D2, d'un second matériau bidimensionnel, est fixé à un tampon, par exemple en PDMS (polydiméthylsiloxane), ou bien présenté vers la couche CA à la surface d'une bulle ou d'une goutte tenue par une pipette. Dans ces deux cas, un simple contact du tampon ou de la bulle avec la surface suffit souvent pour larguer (déposer) le feuillet. Dans d'autres cas, le largage du feuillet nécessitera un tampon approprié, par exemple un tampon soluble constitué de KCl. Un micromanipulateur MM déplace latéralement le tampon pour positionner le feuillet F2D2 à la verticale de F2D1, puis s'approche de la surface du support jusqu'à amener les deux feuillets en contact mutuel. Une observation par BALM, effectuée grâce à un système optique du type décrit plus haut en référence à la figure 2A, permet de guider ce déplacement en rendant visibles les feuillets.

Dans le cas où l'objet à positionner (le feuillet F2D2) ne présente pas une symétrie circulaire, la technique selon l'invention permet également d'en déterminer - et contrôler, à l'aide d'un micromanipulateur adapté - l'orientation dans le plan (azimut).

Comme dans le cas d'une sonde de microscopie SPM, décrit plus haut, un étalonnage approprié permet de mesurer la distance et l'inclinaison entre le feuillet F2D2 et la couche CA. Dans ce cas également, il est possible de mettre en œuvre un asservissement.

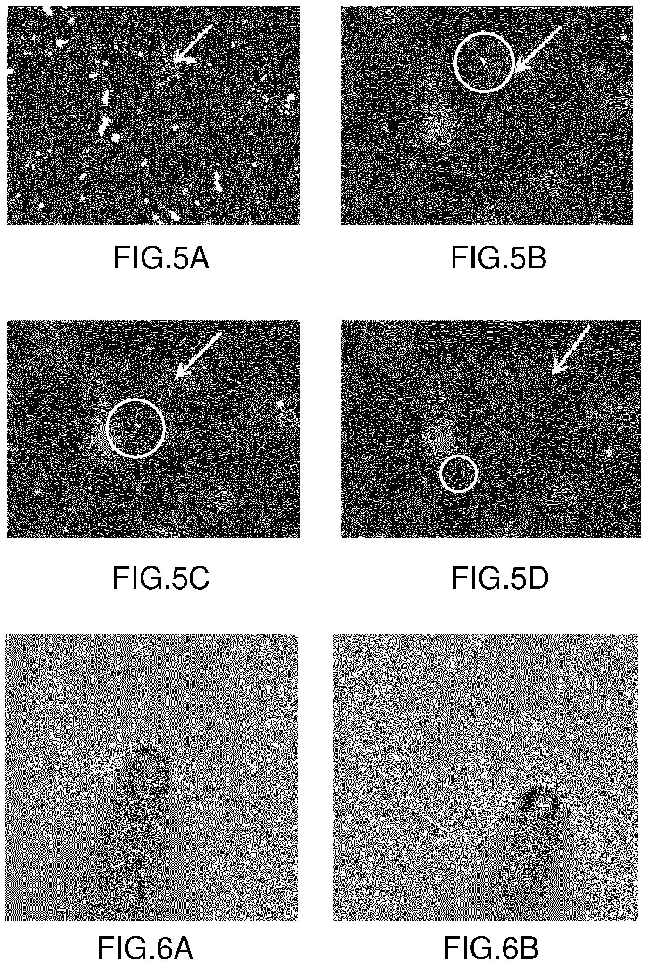

Selon une variante de l'invention, illustrée schématiquement sur la figure 4, il peut aussi être utile de prévoir également une source de lumière auxiliaire SLA, située du même côté du support amplificateur de contraste SAC que l'objet à observer (dans l'exemple de la figure 5, une sonde locale SLM). De préférence, la source de lumière auxiliaire SLA émet un faisceau lumineux auxiliaire FLA frappant la surface du support SAC avec un angle d'incidence non nul, de préférence élevé (supérieur à 45 degrés), et de manière encore préférée rasant (supérieur ou égal à 60 degrés, voire à 70 degrés, ce qui est typiquement au-delà de l'ouverture d'un objectif de microscope). De préférence, toutefois, le faisceau lumineux auxiliaire FLA est suffisamment incliné par rapport à la surface du support SAC et suffisamment large pour éclairer l'objet à observer SLM à la fois directement et par réflexion sur la surface.

Cet éclairage auxiliaire apporte des informations supplémentaires qui peuvent être précieuses pour apprécier, en particulier, la distance h objet-surface. En effet :

- Lorsque le faisceau n'est pas strictement parallèle à la surface, l'objet éclairé par la faisceau FLA projette une ombre sur la couche CA ; la distance entre le pied de cette ombre et la verticale de l'objet renseigne sur la distance h.
- Des figures d'interférences sont engendrées entre la lumière réfléchie par la surface puis diffusée par l'objet, d'une part, et la lumière directement diffusée par l'objet, d'autre part. Ces figures d'interférence sont observables à tavers ladite couche et très dépendants de la distance h. Cet effet est plus important si le faisceau FLA est cohérent temporellement, et notamment si la source SLA est un laser.

Les figures 5A à 5D illustrent l'application d'une méthode selon l'invention au suivi du déplacement d'un objet au-dessus d'un support amplificateur de contraste.

Plus précisément, la figure 5A est une image obtenue avec mise au point sur la surface (contenant du BN exfolié, c'est-à-dire un feuillet de nitrure de bore, et du $MoS_2$ exfolié) du support amplificateur de contraste ; une flèche identifie un point de cette surface, et sert de référence. L'objet à déplacer n'est pas visible. Les figures 5B, 5C et 5D sont des images obtenues avec mise au point sur l'objet (entouré par un cercle) au cours de son déplacement au-dessus de la surface. L'objet (ici du BN exfolié) est clairement visible, et peut donc être positionné de manière précise.

Les figures 6A et 6B sont des images d'une micropipette (diamètre de la pointe égale à 5 $\mu$m environ) vue à travers un support amplificateur de contraste, correspondant à deux distances différentes entre la micropipette et la surface du support (plus faible dans le cas de la figure 6B). La micropipette n'est pas parfaitement perpendiculaire à la surface, et cela est clairement visible sur la figure 6B.

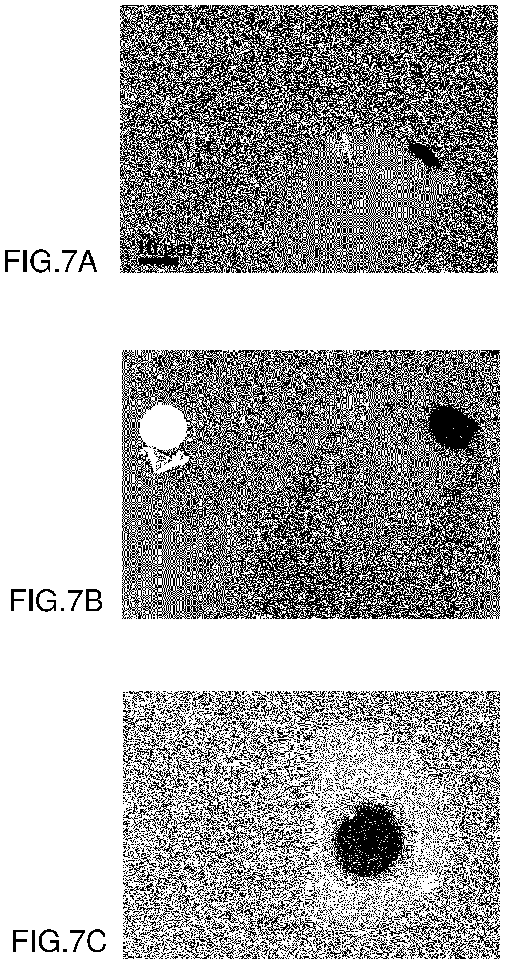

Les figures 7A à 7C sont des images d'une microélectrode (fil conducteur de 10 $\mu$m de diamètre entouré d'une gaine de verre) vue à travers un support amplificateur de contraste. Dans le cas de la figure 7A, la microélectrode est très inclinée par rapport à la normale à la surface (inclinaison supérieure à 25°) ; dans le cas de la figure 7B, elle présente une inclinaison intermédiaire (comprise entre 10° et 15°) et dans celui de la figure 7C elle est sensiblement perpendiculaire à la surface (angle avec la normale inférieur à 5°). Cela permet de constater à quel point l'image observée à travers le substrat dépend de l'inclinaison de la microélectrode. En particulier, les franges d'interférence sont clairement visibles et permettent d'évaluer la symétrie de l'association microélectrode/surface, tant pour l'orientation relatives des deux plans (surface de la microélectrode et surface approchée) que pour la cylindricité de la microélectrode.

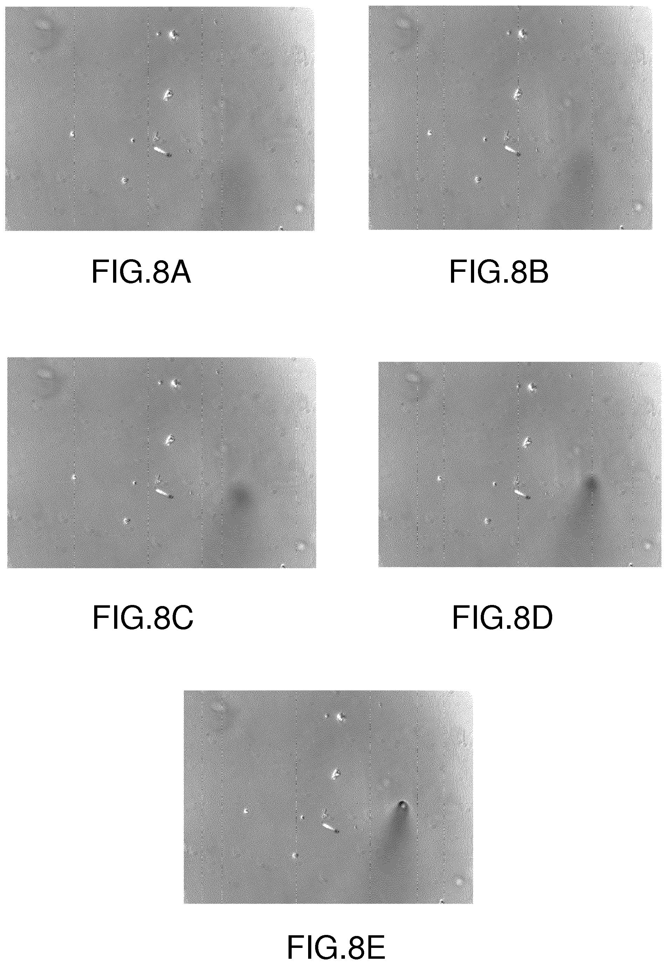

Les figures 8A à 8E sont des images de la micropipette lorsqu'elle se rapproche de la surface du support amplificateur de contraste, vue à travers ledit support avec mise au point sur la surface. La figure 8E correspond à une situation de contact. Le changement progressif de l'image de la pointe de la micropipette permet de suivre précisément son déplacement vertical.

L'invention a été décrite en référence à deux applications particulières, à savoir la microscopie SPM et l'assemblage de matériaux bidimensionnels, mais elle s'applique plus généralement à des nombreux cas où un micro- ou nano-objet doit être positionné de manière précise au-dessus d'une surface solide (ou amené délicatement au contact de cette surface ou d'un objet positionné sur cette surface) qui est ou peut être recouverte d'une couche d'épaisseur nanométrique constituée d'un matériau optiquement absorbant. Par exemple, l'invention s'applique à l'observation, au positionnement et au dépôt contrôlé de micro- ou nano-électrode (ou d'ensembles de telles électrodes portées par un support) à la surface d'un substrat, pour la réalisation de micro- et nano-contacts afin de mesurer des conductivités ou des impédances locales, de fabriquer des circuits électroniques - notamment en électronique moléculaire - des réseaux de neurones artificiels, des dispositifs électrochimiques ou électrocinétiques, etc.

**Revendications**

1. Procédé de positionnement d'un micro- ou nano-objet (SLM, F2D2) au-dessus d'un support plan (SAC), comprenant le déplacement dudit micro- ou nano-objet effectué au moyen d'un micromanipulateur (MM) et sous contrôle visuel, où :

   • ledit micro- ou nano-objet est immergé dans un milieu transparent, dit milieu ambiant (MA), présentant un indice de réfraction $n_3$ ;
   • ledit support plan comprend un substrat transparent (SS) d'indice de réfraction $n_0 > n_3$ sur lequel est déposée au moins une couche optiquement absorbante (CA), adaptée pour se comporter en tant que revêtement antireflet lorsqu'elle est éclairée en incidence normale à une longueur d'onde d'éclairage $\lambda$ à travers ledit substrat transparent (SS) ; et
   • le contrôle visuel comprend l'éclairage dudit micro- ou nano-objet au moins à ladite longueur d'onde $\lambda$ en incidence normale à travers ledit substrat transparent (SS) et ladite couche optiquement absorbante (CA), et son observation en réflexion spéculaire également à travers ledit substrat transparent (SS) et ladite couche optiquement absorbante (CA),
   **caractérise en ce que** ledit contrôle visuel comprend
   une caractérisation d'un paramètre choisi parmi la distance entre le micro- ou nano-objet et la couche optiquement absorbante et l'inclinaison du micro- ou nano-objet par rapport à la couche optiquement absorbante, par analyse d'un motif d'interférence optique ou d'une intensité lumineuse réfléchie par ladite couche observé à travers ledit substrat.

2. Procédé selon l'une des revendications précédentes dans lequel dans lequel ladite couche optiquement absorbante est une couche conductrice.

3. Procédé selon l'une des revendications précédentes dans lequel dans lequel ledit éclairage est un éclairage conique autour de la normale à ladite couche optiquement absorbante.

4. Procédé selon l'une des revendications précédentes, dans lequel le contrôle visuel comprend également l'éclairage dudit micro- ou nano-objet par une source de lumière auxiliaire (SLA) située du même côté dudit support plan que ledit micro- ou nano-objet.

5. Procédé selon l'une des revendications précédentes dans lequel ledit micro- ou nano-objet est une sonde pour microscopie par sonde locale (SLM) et son déplacement comprend une approche de ladite sonde à ladite couche optiquement absorbante.

6. Procédé selon la revendication 5 comprenant également le déplacement de ladite sonde dans une direction sensiblement parallèle à ladite couche optiquement absorbante, la distance entre la sonde et la couche étant maintenue constante par un mécanisme d'asservissement exploitant ledit contrôle visuel.

7. Procédé selon l'une des revendications 5 ou 6 comprenant également le déplacement de ladite sonde dans une direction sensiblement parallèle à ladite couche optiquement absorbante, l'orientation de la sonde par rapport à la couche étant maintenue constante par un mécanisme d'asservissement exploitant ledit contrôle visuel.

8. Procédé selon l'une des revendications 5 à 7 dans lequel ladite sonde est une sonde de microscopie électrochimique.

9. Procédé selon l'une des revendications 1 à 4 dans lequel ledit micro- ou nano-objet est une nanostructure bidimensionnelle (F2D2) solidaire d'un support (T) permettant sa manipulation.

10. Procédé de fabrication d'une nanostructure par empilement de nanostructures bidimensionnelles (F2D1, F2D2), comportant le positionnement desdites nanostructures bidimensionnelles par un procédé selon la revendication 9.

**11.** Procédé selon l'une des revendications 1 à 4 dans lequel ledit micro- ou nano-objet comprend au moins une micro- ou nano-électrode solidaire d'un support (T) permettant sa manipulation.

**12.** Procédé de réalisation d'au moins un micro- ou nano-contact par dépôt d'au moins une micro- ou nano-électrode sur la surface d'un substrat, ledit dépôt étant réalisé par un procédé selon la revendication 11.

**13.** Microscope à sonde locale comprenant :

- un support plan (SAC) comprenant un substrat transparent (SS) d'indice de réfraction $n_0$ sur lequel est déposée au moins une couche optiquement absorbante (CA), adaptée pour se comporter en tant que revêtement antireflet lorsqu'elle est éclairée en incidence normale à une longueur d'onde d'éclairage $\lambda$ à travers ledit substrat transparent (SS), et lorsqu'elle est en contact, du côté opposé audit substrat, avec un milieu transparent, dit milieu ambiant, présentant un indice de réfraction $n_3 < n_0$ ;
- une sonde locale (SLM), agencée à proximité d'une surface dudit support plan ;
- un système d'actionnement (MM) configuré pour déplacer ladite sonde locale au-dessus dudit support plan, au moins dans une direction perpendiculaire et dans une direction parallèle audit support ;
- un système optique (LE, LO, MST) configuré pour éclairer ladite sonde locale (SLM) en incidence normale au moins à ladite longueur d'onde $\lambda$ à travers ledit substrat transparent (SS) et ladite couche optiquement absorbante (CA), et l'observer par réflexion spéculaire, également à travers ledit substrat transparent (SS) et ladite couche optiquement absorbante (CA) ;
**caractérisé en ce que**
- ledit microscope à sonde locale comprend également un système d'asservissement (PR, MM) configuré pour caractériser la distance entre la sonde et la couche optiquement absorbante par analyse d'un motif d'interférence optique ou d'une intensité lumineuse réfléchie observé à travers ledit substrat, et piloter ledit système d'actionnement pour maintenir la distance mesurée égale à une consigne.

**14.** Microscope à sonde locale selon la revendication 13, dans lequel ledit système d'asservissement est également configuré pour :

- caractériser l'inclinaison de la sonde par rapport à la couche optiquement absorbante par analyse dudit motif d'interférence optique ou de ladite intensité lumineuse réfléchie observé à travers ledit substrat ;
- piloter ledit système d'actionnement pour maintenir l'inclinaison mesurée égale à une consigne.

**15.** Microscope à sonde locale selon l'une des revendications 13 ou 14, du type SECM.

**16.** Appareil d'assemblage de nanostructures comprenant

- un support plan (SAC) ;
- un système d'actionnement (MM) configuré pour déplacer, autant de fois que nécessaire, au-dessus dudit support plan, un support (T), auquel peut être fixée une nanostructure bidimensionnelle (F2D2) ;
- un substrat transparent (SS) d'indice de réfraction $n_0$ sur lequel est déposée au moins une couche optiquement absorbante (CA), adaptée pour se comporter en tant que revêtement antireflet lorsqu'elle est éclairée en incidence normale à une longueur d'onde d'éclairage $\lambda$ à travers ledit substrat transparent (SS), et lorsqu'elle est en contact, du côté opposé audit substrat, avec un milieu transparent, dit milieu ambiant, présentant un indice de réfraction $n_3 < n_0$ ;
- ledit appareil comprend également un système optique (LE, LO, MST) configuré pour éclairer ledit support en incidence normale au moins à ladite longueur d'onde $\lambda$ à travers ledit substrat transparent (SS), et l'observer par réflexion spéculaire, également à travers ledit substrat transparent (SS) et ladite couche optiquement absorbante (CA)
- un système d'asservissement configuré pour caractériser au moins un des paramètres choisis parmi la distance entre ledit support et la couche optiquement transparente et l'inclinaison dudit support par rapport à la couche optiquement transparente, par analyse d'un motif d'interférence optique ou d'une intensité lumineuse réfléchie observé à travers ledit substrat, et pour asservir ledit système d'actionnement au moyen de cette caractérisation.

**17.** Appareil d'assemblage de nanostructures selon la revendication 16, dans lequel ledit support est adapté pour permettre le largage de ladite nanostructure sur ledit support une fois positionnée.

**EP 3 443 362 B1**

**Patentansprüche**

1. Verfahren zum Positionieren eines Mikro- oder Nanoobjekts (SLM, F2D2) über einem planaren Träger (SAC), das das Bewegen des Mikro- oder Nanoobjekts mittels eines Mikromanipulators (MM) und unter Sichtkontrolle beinhaltet, wobei:

   • das Mikro- oder Nanoobjekt in ein transparentes Medium, Umgebungsmedium (AM) genannt, mit Brechungsindex $n_3$ eingetaucht wird;
   • der planare Träger ein transparentes Substrat (SS) mit Brechungsindex $n_0 > n_3$ umfasst, auf dem mindestens eine optisch absorbierende Schicht (CA) abgesetzt ist, die so beschaffen ist, dass sie sich als Antireflexionsschicht verhält, wenn sie unter normalem Einfall bei einer Beleuchtungswellenlänge $\lambda$ durch das transparente Substrat (SS) beleuchtet wird; und
   • die Sichtkontrolle das Beleuchten des Mikro- oder Nanoobjekts zumindest bei der Wellenlänge $\lambda$ unter normalem Einfall durch das transparente Substrat (SS) und die optisch absorbierende Schicht (CA) und das Beobachten desselben in Spiegelreflexion ebenfalls durch das transparente Substrat (SS) und die optisch absorbierende Schicht (CA) beinhaltet,

   **dadurch gekennzeichnet, dass** die Sichtkontrolle eine Charakterisierung eines Parameters umfasst, ausgewählt aus dem Abstand zwischen dem Mikro- oder Nanoobjekt und der optisch absorbierenden Schicht und der Neigung des Mikro- oder Nanoobjekts in Bezug auf die optisch absorbierende Schicht, durch Analysieren eines optischen Interferenzmusters oder einer von der Schicht reflektierten Lichtintensität, beobachtet durch das Substrat.

2. Verfahren nach dem vorherigen Anspruch, wobei die optisch absorbierende Schicht eine leitfähige Schicht ist.

3. Verfahren nach einem der vorherigen Ansprüche, wobei die Beleuchtung eine konische Beleuchtung um die Normale zur optisch absorbierenden Schicht ist.

4. Verfahren nach einem der vorherigen Ansprüche, wobei die Sichtkontrolle auch das Beleuchten des Mikro- oder Nanoobjekts durch eine Zusatzlichtquelle (ALS) umfasst, die sich auf der gleichen Seite des planaren Trägers wie das Mikro- oder Nanoobjekt befindet.

5. Verfahren nach einem der vorherigen Ansprüche, wobei das Mikro- oder Nanoobjekt eine Sonde für lokale Sondenmikroskopie (SPM) ist und seine Bewegung eine Annäherung der Sonde an die optisch absorbierende Schicht beinhaltet.

6. Verfahren nach Anspruch 5, das auch das Bewegen der Sonde in einer Richtung im Wesentlichen parallel zur optisch absorbierenden Schicht beinhaltet, wobei der Abstand zwischen der Sonde und der Schicht durch einen Servomechanismus konstant gehalten wird, der die Sichtkontrolle betreibt.

7. Verfahren nach Anspruch 5 oder 6, das auch das Bewegen der Sonde in einer Richtung im Wesentlichen parallel zu der optisch absorbierenden Schicht beinhaltet, wobei die Orientierung der Sonde relativ zur Schicht durch einen Servomechanismus, der die Sichtkontrolle betreibt, konstant gehalten wird.

8. Verfahren nach einem der Ansprüche 5 bis 7, wobei die Sonde eine elektrochemische Mikroskopiesonde ist.

9. Verfahren nach einem der Ansprüche 1 bis 4, wobei das Mikro- oder Nanoobjekt eine zweidimensionale Nanostruktur (F2D2) einstückig mit einem Träger (T) ist, der ihre Manipulation zulässt.

10. Verfahren zur Herstellung einer Nanostruktur durch Stapeln zweidimensionaler Nanostrukturen (F2D1, F2D2), das das Positionieren der zweidimensionalen Nanostrukturen mit einem Verfahren nach Anspruch 9 beinhaltet.

11. Verfahren nach einem der Ansprüche 1 bis 4, wobei das Mikro- oder Nanoobjekt mindestens eine Mikro- oder Nanoelektrode einstückig mit einem Träger (T) umfasst, der ihre Manipulation zulässt.

12. Verfahren zur Herstellung mindestens eines Mikro- oder Nanokontakts durch Absetzen mindestens einer Mikro- oder Nanoelektrode auf der Oberfläche eines Substrats, wobei das Absetzen mit einem Verfahren nach Anspruch 11 erfolgt.

**14**

**13.** Lokales Sondenmikroskop, das Folgendes umfasst:

- einen planaren Träger (SAC), der ein transparentes Substrat (SS) mit Brechungsindex $n_0$ umfasst, auf dem mindestens eine optisch absorbierende Schicht (CA) abgesetzt ist, die so beschaffen ist, dass sie sich als Antireflexionsschicht verhält, wenn sie bei normalem Einfall mit einer Beleuchtungswellenlänge $\lambda$ durch das transparente Substrat (SS) beleuchtet wird und wenn sie auf der dem Substrat gegenüberliegenden Seite mit einem transparenten Medium, Umgebungsmedium genannt, in Kontakt steht, das einen Brechungsindex $n_3 < n_0$ aufweist;

- eine lokale Sonde (SLM), die in der Nähe einer Oberfläche des planaren Trägers angeordnet ist;

- ein Betätigungssystem (MM), konfiguriert zum Bewegen der lokalen Sonde über den planaren Träger zumindest in einer lotrechten Richtung und in einer Richtung parallel zu diesem Träger;

- ein optisches System (LE, LO, MST), konfiguriert zum Beleuchten der lokalen Sonde (SLM) bei normalem Einfall mindestens bei der Wellenlänge $\lambda$ durch das transparente Substrat (SS) und die optisch absorbierende Schicht (CA) und zum Beobachten derselben durch Spiegelreflexion ebenfalls durch das transparente Substrat (SS) und die optisch absorbierende Schicht (CA), **dadurch gekennzeichnet, dass**

- das lokale Sondenmikroskop auch ein Servosystem (PR, MM) umfasst, konfiguriert zum Charakterisieren des Abstands zwischen der Sonde und der optisch absorbierenden Schicht, durch Analysieren eines optischen Interferenzmusters oder einer durch das Substrat beobachteten reflektierten Lichtintensität und Ansteuern des Betätigungssystems, um den gemessenen Abstand gleich einem Sollwert zu halten.

**14.** Lokales Sondenmikroskop nach Anspruch 13, wobei das Servosystem auch konfiguriert ist zum:

- Charakterisieren der Neigung der Sonde in Bezug auf die optisch absorbierende Schicht durch Analysieren des optischen Interferenzmusters oder der reflektierten Lichtintensität, beobachtet durch das Substrat;

- Ansteuern des Betätigungssystems, um die gemessene Neigung gleich einem Sollwert zu halten.

**15.** Lokales Sondenmikroskop nach einem der Ansprüche 13 oder 14 vom Typ SECM.

**16.** Vorrichtung zur Montage von Nanostrukturen, die Folgendes umfasst:

- einen planaren Träger (SAC);

- ein Betätigungssystem (MM), konfiguriert zum Bewegen eines Trägers (T), an dem eine zweidimensionale Nanostruktur (F2D2) befestigt werden kann, so oft wie nötig über den planaren Träger;

- ein transparentes Substrat (SS) mit Brechungsindex $n_0$, auf dem mindestens eine optisch absorbierende Schicht (CA) abgesetzt ist, die so beschaffen ist, dass sie sich als Antireflexionsbeschichtung verhält, wenn sie bei normalem Einfall mit einer Beleuchtungswellenlänge $\lambda$ durch das transparente Substrat (SS) beleuchtet wird, und wenn es auf der dem Substrat gegenüberliegenden Seite mit einem transparenten Medium, Umgebungsmedium genannt, in Kontakt ist, das einen Brechungsindex $n_3 < n_0$ hat;

- wobei die Vorrichtung auch ein optisches System (LE, LO, MST) umfasst, konfiguriert zum Beleuchten des Trägers unter normalem Einfall mindestens bei der Wellenlänge $\lambda$ durch das transparente Substrat (SS) und zum Beobachten desselben durch Spiegelreflexion auch durch das transparente Substrat (SS) und die optisch absorbierende Schicht (CA);

- ein Servosystem, konfiguriert zum Charakterisieren mindestens eines der Parameter, ausgewählt aus dem Abstand zwischen dem Träger und der optisch transparenten Schicht und der Neigung des Trägers in Bezug auf die optisch transparente Schicht, durch Analysieren eines optischen Interferenzmusters oder einer reflektierten Lichtintensität, beobachtet durch den Träger, und zum Steuern des Betätigungssystems mit Hilfe dieser Charakterisierung.

**17.** Vorrichtung zur Montage von Nanostrukturen nach Anspruch 16, wobei der Träger so ausgelegt ist, dass die Nanostruktur nach ihrer Positionierung auf dem Träger freigegeben werden kann.

**Claims**

**1.** A method for positioning a micro-or nano-object (SLM, F2D2) above a flat support (SAC), comprising moving said micro-or nano-object by means of a micromanipulator (MM) and under visual control, wherein:

• said micro- or nano-object is immersed in a transparent medium, called ambient medium (MA), having a

refractive index $n_3$;

• said flat support comprises a transparent substrate (SS) with a refractive index $n_0 > n_3$, on which substrate at least one optically absorbent layer (CA) is deposited that is adapted to act as an anti-reflective coating when it is illuminated at normal incidence at an illumination wavelength $\lambda$ through said transparent substrate (SS); and

• the visual control involves illuminating said micro- or nano-object at least at said wavelength $\lambda$ at normal incidence through said transparent substrate (SS) and said optically absorbent layer (CA), and observing it by specular reflection also through said transparent substrate (SS) and said optically absorbent layer (CA), **characterised in that** said visual control involves characterising a parameter selected from the distance between the micro-or nano-object and the optically absorbent layer and the incline of the micro- or nano-object relative to the optically absorbent layer by analysing an optical interference pattern or a light intensity reflected by said layer observed through said substrate.

2. The method as claimed in the preceding claim, wherein said optically absorbent layer is a conductive layer.

3. The method as claimed in any of the preceding claims, wherein said illumination is a conical illumination around the normal to said optically absorbent layer.

4. The method as claimed in any of the preceding claims, wherein the visual control further comprises illuminating said micro- or nano-object with an auxiliary light source (SLA) located on the same side of said flat support as said micro- or nano-object.

5. The method as claimed in any of the preceding claims, wherein said micro-or nano-object is a probe for local probe microscopy (SPM) and its displacement involves approaching said probe towards said optically absorbent layer.

6. The method as claimed in claim 5, further comprising moving said probe in a direction substantially parallel to said optically absorbent layer, with the distance between the probe and the layer being kept constant by a servocontrol mechanism operating said visual control.

7. The method as claimed in any of claims 5 or 6, further comprising moving said probe in a direction substantially parallel to said optically absorbent layer, with the orientation of the probe relative to the layer being kept constant by a servocontrol mechanism operating said visual control.

8. The method as claimed in any of claims 5 to 7, wherein said probe is an electrochemical microscopy probe.

9. The method as claimed in any of claims 1 to 4, wherein said micro- or nano-object is a two-dimensional nanostructure (F2D2) integral with a support (T) allowing the manipulation thereof.

10. A method for manufacturing a nanostructure by stacking two-dimensional nanostructures (F2D1, F2D2), involving positioning said two-dimensional nanostructures using a method as claimed in claim 9.

11. The method as claimed in any of claims 1 to 4, wherein said micro- or nano-object comprises at least one micro- or nano-electrode integral with a support (T) allowing the manipulation thereof.

12. A method for producing at least one micro- or nano-contact by depositing at least one micro- or nano-electrode onto the surface of a substrate, said deposition being carried out using a method as claimed in claim 11.

13. A local probe microscope comprising:

- a flat support (SAC) comprising a transparent substrate (SS) with a refractive index $n_0$, on which substrate at least one optically absorbent layer (CA) is deposited that is adapted to act as an anti-reflective coating when it is illuminated at normal incidence at an illumination wavelength $\lambda$ through said transparent substrate (SS), and when it is in contact, on the side opposite said substrate, with a transparent medium, called ambient medium, having a refractive index $n_3 < n_0$;

- a local probe (SLM), arranged in the vicinity of a surface of said flat support;

- an activation system (MM) configured to move said local probe above said flat support, at least in a perpendicular direction and in a direction parallel to said support;

- an optical system (LE, LO, MST) configured to illuminate said local probe (SLM) at normal incidence at least at said wavelength $\lambda$ through said transparent substrate (SS) and said optically absorbent layer (CA), and to observe it by specular reflection, also through said transparent substrate (SS) and said optically absorbent layer (CA); **characterised in that** said local probe microscope further comprises a servocontrol system (PR, MM) configured to characterise the distance between the probe and the optically absorbent layer by analysing an optical interference pattern or a reflected light intensity observed through said substrate, and controlling said activation system to keep the measured distance equal to a setpoint.

14. The local probe microscope as claimed in claim 13, wherein said servocontrol system is also configured to:

- characterise the incline of the probe relative to the optically absorbent layer by analysing said optical interference pattern or said reflected light intensity observed through said substrate;
- control said activation system to keep the measured inclination equal to a setpoint.

15. The local probe microscope as claimed in any of claims 13 or 14, of the SECM type.

16. An apparatus for assembling nanostructures comprising:

- a flat support (SAC);
- an activation system (MM) configured to move, as many times as necessary, above said flat support, a support (T), to which a two-dimensional nanostructure (F2D2) can be fixed;
- a transparent substrate (SS) with a refractive index $n_0$, on which substrate at least one optically absorbent layer (CA) is deposited that is adapted to act as an anti-reflective coating when it is illuminated at normal incidence at an illumination wavelength $\lambda$ through said transparent substrate (SS), and when it is in contact, on the side opposite said substrate, with a transparent medium, called ambient medium, having a refractive index $n_3 < n_0$;
- said apparatus further comprises an optical system (LE, LO, MST) configured to illuminate said support at normal incidence at least at said wavelength $\lambda$ through said transparent substrate (SS), and to observe it by specular reflection, also through said transparent substrate (SS) and said optically absorbent layer (CA);
- a servocontrol system configured to characterise at least one of the parameters selected from the distance between said support and the optically absorbent layer and the incline of said support relative to the optically absorbent layer by analysing an optical interference pattern or a reflected light intensity observed through said substrate, and to servocontrol said activation system by means of this characterisation.

17. The apparatus for assembling nanostructures as claimed in claim 16, wherein said support is adapted to allow said nanostructure to be released onto said support once positioned.

MA

CA

MI

$n_3$

$N_1 = n_1 - jk_1$

$e_1$

$n_0$

$\lambda$ FL

## FIG.1

MM

MA

SLM

CA

SS

SAC

H

LO

MST

PR

FL

CM

## FIG.2A

FIG.2B

FIG.4

FIG.3

FIG.5A

FIG.5B

FIG.5C

FIG.5D

FIG.6A

FIG.6B

FIG.7A

10 µm

FIG.7B

FIG.7C

FIG.8A

FIG.8B

FIG.8C

FIG.8D

FIG.8E

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2015055809 A

- WO 2015121462 A

**Littérature non-brevet citée dans la description**

- **M. A. O'CONNELL ; A. J. WAIN.** Combined electro-chemical-topographical imaging : a critical review. *Anal. Methods,* 2015, vol. 7 (17), 6983-6999
- **L. BRITNELL et al.** Strong Light-Matter Interactions in Heterostructures of Atomically Thin Films. *Science,* 2013, vol. 340, 1311
- **T. GEORGIOU et al.** Vertical Field Effect Transistor based on Graphene-WS2 Heterostructures for flexible and transparent electronics. *Nature nanotechnology,* 2013, vol. 8 (2), 100-103

- **AUSSERRÉ, D. ; AMRA, C. ; ZERRAD, M. ; KHACHFE, R. A.** Absorbing Backside Anti-reflecting Layers for high contrast imaging in fluid cells. *No. arXiv: 1405.7672,* 2014
- **D. AUSSERRÉ et al.** Absorbing Backside Anti-reflecting Layers for high contrast imaging in fluid cells. *Journal of Nanomedicine and Nanotechnology,* 21 Juillet 2014, vol. 05 (04